# EUROPEAN PATENT SPECIFICATION

(11) **EP 1 744 608 B1**
(45) Date of publication and mention of the grant of the patent: **25.06.2008**
(21) Application number: 06020624.0
(22) Date of filing: 21.05.1999
(51) Int. Cl.: H05K 3/46

(54) **Multilayer printed wiring board**
Mehrlagen Gedruckteschaltungsplatte
Plaquette multicouche à circuits imprimés

(30) Priority: 13.04.1999 JP 10554999
(43) Date of publication of application: 17.01.2007
(62) Divisional of application: 99921226.9
(73) Proprietor: IBIDEN CO., LTD., Ogaki-shi, Gifu-ken 503-0917 (JP)
(72) Inventor: Asai, Motoo, Ibi-gun, Gifu 501-0601 (JP); Kariya, Takashi, Ibi-gun, Gifu 501-0601 (JP); Shimada, Kenichi, Ibi-gun, Gifu 501-0601 (JP); Segawa, Hiroshi, Ibi-gun, Gifu 501-0601 (JP)
(74) Representative: Grünecker, Kinkeldey, Stockmair & Schwanhäusser Anwaltssozietät

(56) References cited:
- EP-A- 0 800 336
- EP-A- 0 804 061
- US-A- 5 473 120

## Description

### TECHNICAL FIELD

This invention relates to a multilayer printed wiring board and more particularly it proposes the construction of the multilayer printed wiring board suitable for high densification of through-holes capable of sufficiently ensuring electrical connection to an innerlayer circuit through the through-holes even in the multilayer formation of a core board.

### BACKGROUND ART

Recently, a package board mounting an IC chip is demanded to be high in the densification through fine pattern and high in the reliability in correspondence with miniaturization and high speed performance of electronic equipment with the advance of electronic industry.

As such a package board, "Surface Mounting Technique" published on January , 1997 discloses that build-up multilayer wiring layers are formed on both surfaces of a multilayer core board.

In the package board according to the above conventional technique, however, the connection between the conductor layer in the multilayer core board and the build-up wiring layer is carried out by forming an innerlayer pad wired from a through-hole on the surface of the multilayer core board and connecting a via-hole to the innerlayer pad. For this end, a land shape of the through-hole becomes a potbelly or a dumbbell, so that the zone of the innerlayer pad obstructs the improvement of the arrangement density of the through-holes and hence the number of the through-holes to be formed is critical. Therefore, if it is intended to form the multilayer on the core board for a high wiring densification, there is a problem that the build-up wiring layer as an outer layer can not ensure the sufficient electrical connection to the conductor layers in the multilayer core board.

The document EP 0800336 discloses a multilayer printed wiring board comprising a multilayer core board and a buildup wiring layer. The multilayer core board comprises a core substrate having inner conductor circuit layers formed on the core substrate, a resin insulating layer covering the inner conductor circuit layers, a via-hole formed in the resin insulating layer and a through-hole formed in the resin insulating layer and the core substrate to pass therethrough. The through-hole has an inner wall face roughened by a roughening treatment and being filled with a filler. The buildup wiring layer comprises an interlaminar resin insulating layer and an outer conductor circuit layer laminated on the multilayer core board. Va-holes are formed in the interlaminar resin insulating layer.

An object of the invention is to provide a multilayer printed wiring board suitable for the high densification of through-holes capable of sufficiently ensuring the electrical connection to an innerlayer conductor circuit in the core board through the through-holes even in the formation of multilayer on the core board.

### DISCLOSURE OF THE INVENTION

The inventors have made various studies in order to achieve the above object and found that the via-holes of the buildup wiring layer are not connected to the through-holes through the pads but these via-holes are formed just above the through-holes and directly connected to the through-holes or through conductor layers covering the through-holes, whereby the arranging density of the through-holes is increased and the sufficient connection to the innerlayer conductor circuits of the multilayer core board can be ensured through such highly densified through-holes and as a result, the invention has been accomplished. The above object is solved by the features of claim 1.

In the multilayer printed wiring board according to the invention, it is favorable that a conductor layer is formed so as to cover a surface of the filler exposed outward from an opening end of the through-hole, and a part of the via-hole in the buildup wiring layer is connected to the through-hole through the conductor layer.

In the multilayer printed wiring board according to the invention, the filler filled in the through-hole is favorable to be comprised of metal particles and a thermosetting or thermoplastic resin.

### BRIEF DESCRIPTION OF THE DRAWINGS

Figs. 1(a)-(f) are diagrammatic views illustrating a part of steps for producing a multilayer printed wiring board according to the invention.
Figs. 2(a)-(e) are diagrammatic views illustrating a part of steps for producing a multilayer printed wiring board according to the invention.
Figs. 3(a)-(d) are diagrammatic views illustrating a part of steps for producing a multilayer printed wiring board according to the invention.
Figs. 4(a) and (b) are diagrammatic views illustrating a part of steps for producing a multilayer printed wiring board according to the invention.

### BEST MODE FOR CARRYING OUT THE INVENTION

The multilayer printed wiring board according to the invention lies in a point that the innerlayer conductor circuit is connected to the buildup wiring layer through the through-hole formed in the multilayer core board, and further the filler is filled in the through-hole formed in the multilayer core board and a part of the via-hole in the buildup wiring layer is located just above the through-hole to connect to the through-hole or the conductor layer formed so as to cover the exposed face of the through-hole, whereby the connection between the buildup wiring board and the through-hole is attained.

According to the above construction of the invention, a dead space is eliminated by acting a region just above the through-hole as an innerlayer pad and also it is not required to conduct the wiring of the innerlayer pad for the connection from the through-hole to the via-hole, so that a land shape of the through-hole can be rendered into a true circle. As a result, the arranging density of the through-holes formed in the multilayer core board is improved and it is possible to sufficiently connect the outerlayer buildup wiring layer to the innerlayer conductor circuit in the multilayer core board through the highly densified through-holes.

In the multilayer printed wiring board according to the invention, a structure that the buildup wiring boards are formed on both surfaces of the multilayer core board is adopted for increasing the wiring density.

The multilayer core board is formed so as to alternately laminate the innerlayer conductor circuits and the interlaminar insulating layers on the core board and connect the innerlayer conductor circuits to each other through the via-hole, which is formed in the same manner as the outerlayer buildup wiring layer mentioned later.

In the multilayer printed wiring board according to the invention, the filler is filled in the through-hole formed in the multilayer core board. The filler is favorable to be comprised of metal particles, a thermosetting resin and a curing agent, or of metal particles and a thermoplastic resin, and may be added with a solvent, if necessary. Since the filler contains the metal particles, when the surface of the filler is subjected to polishing, the metal particles are exposed and the filler is integrally united with the plated film of the conductor layer formed thereon through the exposed metal particles, so that the peeling at the boundary face to the conductor layer hardly occurs even under severer condition of higher temperature and higher humidity such as PCT (pressure cooker test). And also, the filler is filled in the through-hole provided on its wall face with the metal film, so that there is not caused migration of metal ion.

As the metal particles, use may be made of copper, gold, silver, aluminum, nickel, titanium, chromium, tin/lead, palladium, platinum and the like.

Moreover, the particle size of these metal particles is favorable to be 0.1-50 µm. When the particle size is less than 0.1 µm, the copper surface is oxidized to degrade the wettability to the resin, while when it exceeds 50 µm, the printability is degraded.

The amount of the metal particles compounded is favorable to be 30-90 wt% based on the total amount. When it is less than 30 wt%, the adhesion property to the cover plated film (conductor layer formed so as to cover the exposed surface from the through-hole), while when it exceeds 90 wt%, the printability is degraded.

As the resin, use may be made of bisphenol A-type epoxy resin, bisphenol F-type epoxy resin, phenolic resin, polyimide resin, fluorine resin such as polytetrafluoroethylene (PTFE) or the like, biamaleimide triazine (BT) resin, FEP, PFA, PPS, PEN, PES, nylon, aramid, PEEK, PEKK, PET and so on.

As the curing agent, use may be made of imidazole-based, phenol-based, amine-based curing agents and so on.

As the solvent, use may be made of NMP (normal methyl pyrolidone), DMDG (diethylene glycol dimethyl ether), glycerine, water, 1- or 2- or 3-cyclohexanol, cyclohexanone, methylcellosolve, methylcellosolve acetate, methanol, ethanol, butanol, propanol and so on.

Particularly, the optimum composition of the filler is preferable to be a combination of a mixture of Cu powder and bisphenol F-type solvent-free epoxy resin (E-807, trade name, made by Yuka Shell Co., Ltd.) at a weight ratio of 6:4-9:1 and a curing agent, or a combination of Cu powder, PPS and NMP at a weight ratio of 8:2:3.

The filler is desirable to be non-conductive because the curing shrinkage is small and the peeling from the conductor layer or the via-hole hardly occurs in case of the non-conductivity.

In the multilayer printed wiring board according to the invention, it is desirable that a roughened layer is formed on the conductor surface in the inner wall face of the through-hole to be filled with the filler. When the roughened layer is formed on the conductor surface of the inner wall face of the through-hole, the filler is closely adhered to the through-hole through the filler to cause no gap. If the gap is existent between the filler and the through-hole, the conductor layer formed just thereabove through electrolytic plating becomes not flat or air in the gap is thermally expanded to cause the cracking or peeling, while water is retained in the gap to result in the migration or cracking. In this connection, the formation of the roughened layer can prevent the occurrence of the above problems.

According to the invention, it is advantageous that the same roughened layer as the roughened layer formed on the conductor surface in the inner wall face of the through-hole is formed on the surface of the conductor layer covering the exposed surface of the filler from the through-hole because the adhesion property to the interlaminar resin insulating layer or the via-hole through the roughened layer can be improved. Particularly, when the roughened layer is formed on the side face of the conductor layer, there can be suppressed the cracking produced toward the interlaminar resin insulating layer from the boundary between the side face of the conductor layer and the interlaminar resin insulating layer due to the lacking of adhesion therebetween.

It is favorable that the thickness of the roughened layer formed on the inner wall face of the through-hole or the surface of the conductor layer is 0.1-10 µm. When the thickness is too thick, short-circuit is produced between the layers, while when it is too thin, the adhesion force to adherent lowers.

The roughened layer is favorable to be formed by subjecting the conductor in the inner wall face of the through-hole or the surface of the conductor layer to oxidation (graphitization)-reduction treatment, a treatment with an aqueous mixed solution of an organic acid and a copper(II) complex, or a plating treatment with copper-nickel-phosphorus needle-shaped alloy.

Among these treatments, the oxidation (graphitization)-reduction treatment uses an oxidation bath (graphitization bath) of NaOH (10 g/l), NaClO₂ (40 g/l) and Na₃PO₄ (6 g/l) and a reduction bath of NaOH (10 g/l) and NaBH₄ (6 g/l).

In the treatment using the aqueous mixed solution of organic acid and copper (II) complex, the metal foil such as copper or the like as the conductor circuit is dissolved by spraying or bubbling under a coexistence condition of oxygen as follows:

Cu + CU(II)Aₙ → 2Cu(II)A_{n/2}

2Cu(II)A_{n/2} + n/4O₂ + nAH (areation) → 2Cu(II)Aₙ + n/2H₂O

wherein A is a complexing agent (acting as a chelating agent) and n is a coordination number.

The copper(II) complex used in this treatment is favorable to be a copper(II) complex of an azole. The copper(II) complex of azole acts as an oxidizing agent for oxidizing metallic copper or the like. The azole includes diazoles, triazoles and tetrazoles. Among them, imidazole, 2-methyl imidazole, 2-ethyl imidazole, 2-ethyl-4-methyl imidazole, 2-phenyl imidazole, 2-undecyl imidazole and so on are preferable.

The content of the copper(II) complex of azole is favorable to be 1~15% by weight. The solubility and stability are excellent in this range.

And also, the organic acid is compounded for dissolving the copper oxide.

Concretely, it is favorable to use at least one selected from the group consisting of formic acid, acetic acid, propionic acid, butyric acid, valeric acid, caproic acid, acrylic acid, crotonic acid, oxalic acid, malonic acid, succinic acid, gultaric acid, maleic acid, benzoic acid, glycolic acid, lactic acid, malic acid and sulfamic acid.

The content of the organic acid is favorable to be 0.1~30% by weight for maintaining the solubility of the oxidized copper and ensuring the dissolution stability.

Moreover, the generated copper(I) complex is dissolved by the action of the acid and bonded to oxygen to form a copper(II) complex, which again contributes to the oxidation of copper.

An inorganic acid such as borofluoric acid, hydrochloric acid, sulfuric acid or the like may be added in addition to the organic acid.

The etching solution of organic acid-copper(II) complex may be added with a halogen ion such as fluorine ion, chlorine ion, bromine ion or the like for assisting the dissolution of copper and the oxidation of the azole. The halogen ion may be supplied by adding hydrochloric acid, sodium chloride or the like.

The amount of the halogen ion is favorable to be 0.01~20% by weight. The adhesion property between the roughened layer and the interlaminar resin insulating layer is excellent in this range.

The etching solution of organic acid-copper(II) complex is prepared by dissolving the copper(II) complex of the azole and the organic acid (if necessary, halogen ion) in water.

In the plating treatment of copper-nickel-phosphorus needle-shaped alloy, it is desirable to use a plating solution having a liquid composition of 1-40 g/l of copper sulfate, 0.1-6.0 g/l of nickel sulfate, 10-20 g/l of citric acid, 10-100 g/l of hypophosphate, 10-40 g/l of boric acid and 0.01-10 g/l of a surfactant.

In the invention, as the interlaminar resin insulating layer used in the buildup wiring layer, use may be made of a thermosetting resin, a thermoplastic resin and a composite of thermosetting resin and thermoplastic resin.

As the thermosetting resin, use may be made of epoxy resin, polyimide resin, phenol resin, thermosetting polyphenylene ether (PPE) and the like.

As the thermoplastic resin, use may be made of a fluorine resin such as polytetrafluoroethylene (PTFE) or the like, polyethylene terephthalate (PET), polysulphone (PSF), polyphenylene sulfide (PPS), thermoplastic polyphenylene ether (PPE), polyether sulphone (PES), polyether imide (PEI), polyphenylene sulphone (PPES), ethyele tetrafluoride-propylene hexafluoride copolymer (FEP), ethylene tetrafluoride perfluoroalkoxy xopolymer (PFA), polyethylene naphthalate (PEN), polyether ether ketone (PEEK), polyolefin resin and so on.

As the composite of thermosetting resin and thermoplastic resin, use may be made of epoxy resin-PES, epoxy resin-PSF, epoxy resin-PPS, epoxy resin-PPES and so on.

In the invention, an adhesive for electroless plating may be used as the interlaminar resin insulating layer.

As the adhesive for electroless plating, it is optimum to use an adhesive obtained by dispersing cured heat-resistant resin particles soluble in an acid or oxidizing agent into uncured heat-resistant resin hardly soluble in an acid or oxidizing agent after a curing treatment. Because, the heat-resistant resin particles are dissolved and removed by treating with the acid or oxidizing agent to form a roughened surface comprised of octopus trap-shaped anchors.

The depth of the roughened surface is favorable to be 0.01-20 µm for ensuring the adhesion property. In case of the semi-additive process, it is 0.1-5 µm because the electroless plated film can be removed while ensuring the adhesion property.

As the cured heat-resistant particles in the adhesive for the electroless plating, it is desirable to use at least one selected from the group consisting of ① heat-resistant resin powder having an average particle size of not more than 10 µm, ② aggregate particles obtained by aggregating heat-resistant resin powder having an average particle size of not more than 2 µm, ③ a mixture of heat-resistant resin powder having an average particle size of 2-10 µm and heat-resistant resin powder having an average particle size of not more than 2 µm, ④ false particles obtained by adhering at least one of heat-resistant resin powder having an average particle size of not more than 2 µm and inorganic powder to surface of heat-resistant resin powder having an average particle size of 2-10 µm, ⑤ a mixture of heat-resistant resin powder having an average particle size of 0.1-0.8 µm and heat-resistant resin powder having an average particle size of more than 0.8 µm but less than 2 µm, and ⑥ heat-resistant resin powder having an average particle size of 0.1-1.0 µm. These particles can form a more complicated anchor.

As the heat-resistant resin used in the adhesive for electroless plating, use may be made of the aforementioned thermosetting resin, thermoplastic resin and the composite of thermosetting resin and thermoplastic resin.

In the invention, the conductor layer (including the layer covering the filler filled in the through-hole) formed on the multilayer core substrate and the outerlayer conductor circuit formed on the interlaminar resin insulating layer can be connected to each other through the via-hole. In this case, the via-hole may be filled with the plated film or the filler.

An example of the production method of the multilayer printed wiring board according to the invention will be described in detail below. Although the method mentioned below is concerned with the production of the multilayer printed wiring board through the semi-additive process, the full-additive process, multi-lamination process and pin-lamination process can also adopted in the production of the multilayer printed wiring board according to the invention.

### (1) Formation of substrate, innerlayer conductor pattern and resin insulating layer

①. The multilayer core board is formed so as to include an innerlayer buildup wiring layer inclusive of innerlayer conductor circuits, insulating resin layer and via-holes as mentioned above, but there is first prepared a board obtained by forming the innerlayer conductor pattern and the resin insulating layer on a surface of a resin substrate.
   As the resin substrate, it is desirable to use a resin substrate containing inorganic fibers. For example, it is favorable to select from glass cloth epoxy resin substrate, glass cloth polyimide substrate, glass cloth bismaleimide triazine substrate, glass cloth fluorine resin substrate and the like.
②. The formation of the innerlayer circuit pattern is carried out by etching a copper clad laminate obtained by laminating copper foils on both surfaces of the resin substrate.
③. Then, the resin insulating layers are formed on both surfaces of the wiring board provided with the innerlayer circuit pattern. The resin insulating layer serves as an interlaminar resin insulating layer in the core board. The resin insulating layer is formed by applying an uncured solution or hot pressing a film-like resin for lamination.

### (2) Formation of through-hole and via-hole

①. Next, a hole (opening for the formation of through-hole) passing through the resin substrate, a part of the innerlayer circuit pattern and the resin insulating layer is formed and an opening for the formation of a via-hole passing through the resin insulating layer to the innerlayer circuit pattern is formed. The formation of the opening for the through-hole is carried out by drilling work or a laser work, and the formation of the opening for the formation of the via-hole is carried out by a laser work or a light exposure-development treatment. In this case, carbon dioxide gas laser, ultraviolet ray laser, excimer laser or the like is used as a laser beam.
②. After the formation of the openings, desmiar treatment is conducted. The desmiar treatment can be carried out by using an aqueous solution of chromic acid, permanganate or the like as an oxidizing agent or may be carried out by oxygen plasma, a mixed plasma of CF₄ and oxygen, corona discharge or the like. Alternatively, the surface modification may also be carried out by irradiating an ultraviolet ray through a low-pressure mercury lamp.
③. Then, the inner wall face of the opening for the through-hole, surface of the resin insulating layer and the inner wall face of the opening for the formation of the via-hole are subjected to an electroless plating to form a through-hole and a via-hole.
   As the electroless plating, copper plating is favorable. Moreover, when the surface of the substrate is a resin indicating a bad fitness to the plating usch as fluorine resin or the like, the surface modification such as a pretreatment with an agent made of an organic metal sodium (Tetraetch, trade name, made by Junkosha Co., Ltd.), a plasma treatment or the like may be carried out.
④. Thereafter, an electrolytic plating is carried out for thickening the electroless plated film formed onthe inner wall face of the opening for the through-hole and the surface of the resin insulating layer, and at the same time the electrolytic plating is carried out for the electroless plated film formed on the inner wall face of the opening for the via-hole, whereby the electrolytic plated film is filled in the openings. As the electrolytic plating, copper plating is favorable.
   Furthermore, a roughening layer is formed by subjecting the electrolytic plated film in the inner wall face of the through-hole, the electrolytic plated on the surface of the board and the electrolytic plated film on the surface of the via-hole to a roughening treatment. This roughened layer is formed by a graphitization (oxidation)-reduction treatment, a spraying treatment with an aqueous mixed solution of organic acid and copper(II) complex or a plating of copper-nickel-phosphorus needle-shaped alloy.

### (3) Filling of filler in through-hole

①. The filler having the above construction is filled in the through-hole formed in the item (2). Concretely, the filler is filled in the through-hole by applying onto the board placed with a mask having openings corresponding to the portions of the through-holes through printing process and dried and cured after the filling.
   To the filler may be added a metal surface modifying agent such as silane coupling agent or the like for increasing the adhesion force between the metal particle and the resin. And also, an anti-foaming agent such as acrylic anti-foaming agent, silicone anti-foaming agent or the like, and inorganic filler such as silica, alumina, talc or the like may be added as the other additives. Further, a silane coupling agent may be adhered to the surfaces of the metal particles.
   Such a filler is printed, for example, under the following conditions. That is, the printing is carried out by using a printing mask of Tetron mesh and an angle squeeze of 45° under conditions of Cu paste viscosity: 120 Pa·s, squeeze rate: 13 mm/sec and squeeze pushing quantity: 1 mm.
②. The filler pushed away from the through-hole and roughened layer on the electrolytic plated film surface of the board are removed by polishing to flatten the surface of the board. As the polishing, a belt sander or buffing is favorable.

### (4) Formation of conductor layer (conductor layer covering the conductor circuit and the filler on the core board)

①. After a catalyst nucleus is given to the surface of the board flattened in the item (3), electroless plating is carried out to form an electroless plated film having a thickness of about 0.1-5 µm, and further electrolytic plating is carried out, if necessary, to form an electrolytic plated film having a thickness of 5-25 µm.
   Then, a photosensitive dry film is laminated on the surface of the plated film by hot pressing and a photomask (favorably made of glass) depicted with a pattern is placed thereon, exposed to a light and developed with a developing solution to form an etching resist. Thereafter, conductors in portions not forming the etching resist are dissolved and removed with an etching solution to form conductor layer portions covering the conductor circuit portions (including conductor layer for the connection to the via-hole) and the filler.
   As the etching solution, it is favorable to use an aqueous solution of sulfuric acid-hydrogen peroxide, an aqueous solution of a persulfate such as ammonium persulfate, sodium persulfate, potassium persulfate or the like, and an aqueous solution of iron chloride or copper chloride.
②. After the etching resist is peeled off to form independent conductor circuits and conductor layer covering the filler, roughened layers are formed on the surfaces of the conductor circuits and the conductor layer.

When the roughened layer is formed on the surfaces of the conductor circuit and the conductor layer covering the filler, the adhesion property between the conductor and the interlaminar resin insulating layer is excellent, so that there is not caused the cracking at the boundary among the conductor circuit, side face of the conductor layer covering the filler and the resin insulating layer. On the other hand, the conductor layer covering the filler improves the adhesion property to the via-hole electrically connected thereto.

As the method of forming the roughened layer, there are the graphitization (oxidation)-reduction treatment, needle alloy plating or etching as previously mentioned.

After the roughening, the resin is applied and filled between the conductor circuits and cured and polished till the conductor is exposed from the surface in order to remove the irregularities due to the conductor layer on the board surface.

As the resin, it is desirable to use a resin composition comprising bisphenol type epoxy resin such as bisphenol A-type epoxy resin, bisphenol F-type epoxy resin or the like, an imidazole curing agent and inorganic particles. Because, the bisphenol type epoxy resin is low in the viscosity and the application thereof is easy. And also, the bisphenol F-type epoxy resin is not required to use a solvent, so that the cracking or peeling resulted from the evaporation of the solvent in the curing under heating can advantageously be prevented.

And also, it is desirable to form the roughened layer on the surface of the conductor layer after the polishing.

Moreover, the following steps can be adopted as a method of forming the outerlayer conductor layer.

That is, a plating resist is formed on the board after the steps of the above items (1)-(3) and portions not forming the resist are subjected to an electrolytic plating to form conductor circuits and conductor layer portion, and a solder plated film is formed on these conductors by using an electrolytic solder plating solution comprising tin borofluoride, lead borofluoride, hydroborofluoric acid and peptone, and thereafter the plating resist is removed and the electroless plated film and copper foil beneath the plating resist are removed by etching to form an independent pattern and further the solder plated film is dissolved and removed with an aqueous solution of hydroborofluoric acid to from a conductor layer.

### (5) Formation of interlaminar resin insulating layer and outerlayer conductor circuit

①. An interlaminar resin insulating layer is formed on the thus prepared wiring board.
   As the interlaminar resin insulating layer, use may be made of a thermosetting resin, a thermoplastic resin and a composite of thermosetting resin and thermoplastic resin. In the invention, the aforementioned adhesive for electroless plating may also be used as an interlaminar resin insulating material.
   The interlaminar resin insulating layer is formed by applying an uncured solution of the above resin or by laminating a film-like resin through hot pressing.
②. Next, an opening for the formation of via-hole is formed in the interlaminar resin insulating layer for ensuring electrical connection to a lowerlayer conductor circuit covered with the interlaminar resin insulating layer.
   The formation of the opening is carried out by light exposure and development treatment when the interlaminar resin insulating layer is made from a photosensitive resin, or by a laser beam when it is made from a thermosetting resin or thermoplastic resin. As the laser beam used, there are carbon dioxide gas laser, ultraviolet ray laser, excimer laser and the like. When the opening is formed by the laser beam, desmiar treatment may be conducted. Such a desmiar treatment may be carried out by using an aqueous solution of chromic acid, permanganate or the like as an oxidizing agent, or by oxygen plasma or the like.
③. After the formation of the interlaminar resin insulating layer having the opening, the surface is roughened, if necessary.
   When the above adhesive for electroless plating is used as the interlaminar resin insulating layer, the surface is treated with an oxidizing agent to selectively remove only the heat-resistant resin particles to thereby roughen the surface. Even in case of using the thermosetting resin or thermoplastic resin, it is effective to conduct the surface roughening treatment with the aqueous solution of chromic acid, permanganate or the like as an oxidizing agent. Moreover, in case of the resin hardly roughened with the oxidizing agent such as fluorine resin (polyteterafluoroethylene and the like) or the like, the surface is roughened by plasma treatment, Tetraetch or the like.
④. Next, a catalyst nucleus for electroless plating is applied.
   In general, the catalyst nucleus is palladium-tin colloid. The board is immersed in this solution, dried and heated to fix the catalyst nucleus to the surface of the resin. And also, a metal nucleus may be struck onto the resin surface by CVD, sputtering or plasma as a catalyst nucleus. In the latter case, the metal nucleus is embedded in the resin surface, so that the conductor circuit is formed by precipitating the plated film around the metal nucleus and hence the adhesion property can be ensured in the resin badly adhered to the conductor circuit such as a hardly roughening resin and fluorine resin (polytetrafluoroethylene and the like). As the metal nucleus, there is at least one selected from the group consisting of palladium, silver, gold, platinum, titanium, copper and nickel. Moreover, the amount of the metal nucleus is favorable to be not more than 20 µg/cm². If the amount exceeds this value, the metal nucleus should be removed.
⑤. Then, the surface of the interlaminar resin insulating layer is subjected to an electroless plating to form an electroless plated film on the whole surface. The thickness of the electroless plated film is 0.1-5 µm, preferably 0.5-3 µm.
⑥. Further, a plating resist is formed on the electroless plated film. The plating resist is formed by laminating a photosensitive dry film and subjecting it to light exposure and development treatment as previously mentioned.
⑦. The electrolytic plating is carried out to thicken the conductor circuit portions (including via-hole portion). The thickness of the electrolytic plated film is 5-30 µm. And also, it is desirable to fill the via-hole portion with the electrolytic plated film.
⑧. After the peeling of the plating resist, the electroless plated film beneath the plating resist is removed by dissolving with an etching solution to form independent conductor circuits (including via-holes).

As the etching solution, it is favorable to use an aqueous solution of sulfuric acid-hydrogen peroxide, an aqueous solution of a persulfate such as ammonium persulfate, sodium persulfate, potassium persulfate or the like, or an aqueous solution of iron chloride or copper chloride.

The following examples are given in illustration of the invention and are not intended as limitations thereof.

### EXAMPLES

### (Example 1)

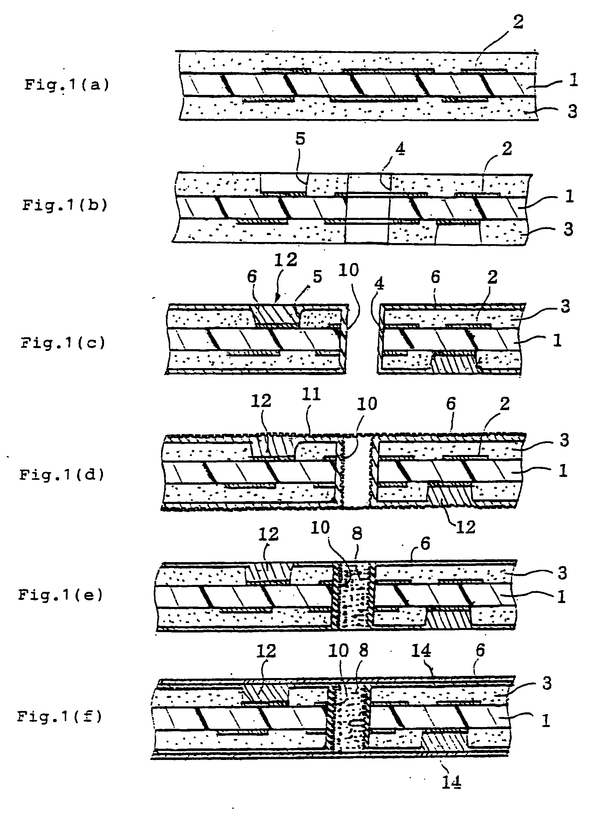

(1) There is provided a copper clad laminate having a thickness of 0.5 mm. At first, etching resists are formed on both surfaces of the laminate and etched with an aqueous solution of sulfuric acid-hydrogen peroxide to obtain a resin substrate 1 having innerlayer conductor circuits 2. Then, a resin having the following composition is applied onto both surfaces of the substrate 1 by means of a roll coater to form resin insulating layers 3, whereby a core board is prepared (see Fig. 1(a)).
①. A mixed composition is prepared by mixing 400 parts by weight of a resin solution dissolving 25% acrylated product of cresol novolac type epoxy resin (made by Nippon Kayaku Co., Ltd. molecular weight: 2500) at a concentration of 80% by weight in diethylene glycol dimethyl ether (DMDG), 60 partsby weight of a photosensitive monomer (Aronix M325, trade name, made by Toa Gosei Co., Ltd.), 5 parts by weight of an atni-foaming agent (S-65, trade name, made by Sannopuco Co., Ltd.) and 35 parts by weight of N-methylpyrolidone (NMP) under stirring.
②. A mixed composition is prepared by mixing 80 parts by weight of polyether sulphone (PES) and 145 parts by weight of epoxy resin particles (Polymerpol, trade name, made by Sanyo Kasei Co., Ltd.) having an average particle size of 0.5 µm with stirring and adding 285 parts by weight of NMP and mixing them in a bead mill under stirring.
③. A mixed composition is prepared by mixing 20 parts by weight of an imidazole curing agent (2E4MZ-CN, trade name, made by Shikoku Kasei Co., Ltd.), 20 parts by weight of benzophenone as a photoinitiator, 4 parts by weight of a photosensitizer (EAB, trade name, made by Hodogaya Kagaku Co., Ltd.) and 16 parts by weight of NMP under stirring.
   The above mixed compositions prepared in ①, ② and ③ are mixed to obtain a resin composition.

(2) Then, an opening 4 for the formation of through-hole having a diameter of 300 µm is formed in the core board by drilling, while openings 5 for the formation of via-hole having a diameter of 50 µm are formed by a laser work so as to arrive at an innerlayer conductor circuit 2 through the resin insulating layer 3 (see Fig. 1(b)).
Next, the core board is roughened with an aqueous solution of 800 g/l of chromic acid, neutralized, washed, adhered with palladium-tin colloid and then subjected to an electroless plating under the following conditions to form an electroless plated film of 0.6 µm in thickness on the hole surface of the board and inner wall faces of the openings.

| [Aqueous electroless plating solution] | |
|---|---|
| EDTA | 150 g/l |
| copper sulfate | 20 g/l |
| HCHO | 30 ml/l |
| NaOH | 40 g/l |
| α,α'-bipyridyl | 80 mg/l |
| PEG | 0.1 g/l |

| [Electroless plating condition] | |
|---|---|
| liquid temperature of 70°C, | 30 minutes |

Then, an electrolytic plating for thickening is carried out under the following conditions to form an electrolytic plated film 6 having a thickness of 15 µm on the surface of the board and the opening 4 to thereby form a through-hole 10, while the electrolytic plated film 6 is filled in the opening 5 for the via-hole provided with the electroless plated film to form a via-hole 12 (see Fig. 1(c)).

| [Aqueous electrolytic plating solution] | |
|---|---|
| sulfuric acid | 180 g/l |
| copper sulfate | 80 g/l |
| additive (Caparasid GL, trade name, made by Atotech Japan Co., Ltd.) | 1 ml/l |
| | |

| [Electrolytic plating condition] | |
|---|---|
| current density | 1 A/dm² |
| time | 30 minutes |
| temperature | room temperature |

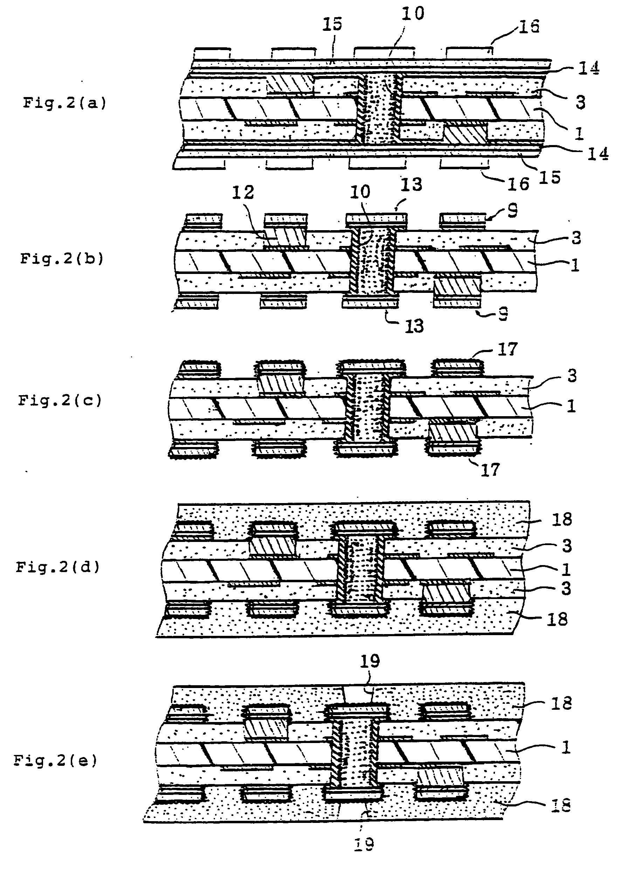

(3) The board provided with the conductors (including through-hole 10 and via-hole 12) made from the electrolytic plated film 6 in the item (2) is washed with water, dried and subjected to an oxidation-reduction treatment using an oxidation bath (graphitization bath) of NaOH (10 g/l), NaClO₂ (40 g/l) and Na₃PO₄ (6 g/l) and a reduction bath of NaOH (10 g/l) and NaBH₄ (6 g/l) to form roughened layer 11 on the whole surface of the conductors including the through-hole 10 and the via-hole 12 (see Fig. 1(d)).
(4) Next, a filler 8 inclusive of copper particles having an average particle size of 10 µm (non-conductive hole-embedding copper paste made by Tatsuta Densen Co., Ltd. trade name: DD Paste) is filled in the through-hole 10 by screen printing, which is dried and cured. Further, the filler 8 stuck out from the roughened layer 11 on the conductor and the through-hole 10 is removed by belt sander polishing using #600 belt polishing paper (made by Sankyo Rika Co., Ltd.) and buffed for removing flaw caused by the belt sander polishing to flatten the surface of the board (see Fig. 1(e)).
(5) A palladium catalyst (made by Atotech) is applied onto the surface of the board flattened in the item (4), which is subjected to an electroless copper plating under the same condition as the item (2) to from an electroless copper plated film having a thickness of 0.6 µm (see Fig. 1(f)).
(6) Then, the electrolytic copper plating is carried out under the same condition as the item (2) to from an electrolytic copper plated film having a thickness of 15 µm, whereby a thickening portion for the conductor circuit 9 and a conductor layer 13 covering the filler 8 filled in the through-hole 10 (circular through-hole land) are formed.
(7) Onto both surfaces of the board provided with the portions for the conductor circuit 9 and the conductor layer 13 are attached commercially available photosensitive dry films and a mask is placed thereonto, which is exposed to a light at 100 mJ/cm² and developed with 0.8% sodium carbonate to form an etching resist 16 having a thickness of 15 µm (see Fig. 2(a)).
(8) The plated film in portions not forming the etching resist 16 are removed by dissolving with an etching mixed solution of sulfuric acid and hydrogen peroxide, and further the etching resist 16 is removed by peeling with 5% KOH to from independent conductor circuits 9 and conductor layer covering the filler 8.
(9) Next, a roughened layer (irregular layer) 17 of 2.5 µm in thickness made of Cu-Ni-P alloy is formed on the surfaces of the conductor circuits 9 and the conductor layer 13 covering the filler 8 and further Sn layer of 0.3 µm in thickness is formed on the surface of the roughened layer 17 (see Fig. 2(c), provided that Sn layer is not shown).
The formation method is as follows. That is, the board is degreased with an acid, soft-etched, treated with a catalyst solution of palladium chloride and organic acid to give a palladium catalyst, and after the activation of the catalyst, it is subjected to a plating in an electroless plating bath of pH = 9 containing 8 g/l of copper sulfate, 0.6 g/l of nickel sulfate, 15 g/l of citric acid, 29 g/l of sodium hypophosphite, 31 g/l of boric acid and 0.1 g/l of a surfactant to form a roughened layer 17 of Cu-Ni-P alloy on the surfaces of the conductor circuits 9 and the conductor layer 13 covering the filler 8. Then, Cu-Sn substitution reaction is carried out under conditions of tin borofluoride: 0.1 mol/l, thiourea: 1.0 mol/l, temperature: 50°C and pH = 1.2 to form Sn layer of 0.3 µm in thickness on the surface of the roughened layer 17 (Sn layer is not shown).
(10) Adhesives A, B for electroless plating are prepared as follows.
A. Preparation of adhesive for electroless plating as an upperlayer
   ①. 35 parts by weight of 25% acrylated product of cresol novolac type epoxy resin (made by Nippon Kayaku Co., Ltd. molecular weight: 2500) (solid content: 80%) is mixed with 3.15 parts by weight of a photosensitive monomer (Aronix M315, trade name, made by Toa Gosei Co., Ltd.), 0.5 part by weight of an anti-foaming agent (S-65, trade name, made by Sannopuco Co., Ltd.) and 3.6 parts by weight of NMP under stirring.
   ②. 12 parts by weight of polyether sulphone (PES) is mixed with 7.2 parts by weight of epoxy resin particles (Polymerpol, trade name, made by Sanyo Kasei Co., Ltd.) having an average particle size of 1.0 µm and 3.09 parts by weight of the epoxy resin particles having an average particle size of 0.5 µm and added with 30 parts by weight of NMP, which are mixed in a bead mill under stirring.
   ③. 2 parts by weight of an imidazole curing agent (2E4MZ-CN, trade name, made by Shikoku Kasei Co., Ltd.) is mixed with 2 parts by weight of a photoinitiator (Irgaquar I-907, trade name, made by Ciba Geigy), 0.2 part by weight of a photosensitizer (DETX-S, trade name, made by Nippon Kayaku Co., Ltd.) and 1.5 parts by weight of NMP under stirring.
   They are mixed to prepare the adhesive composition A for electroless plating.
B. Preparation of adhesive for electroless plating as a lowerlayer
   ①. 35 parts by weight of 25% acrylated product of cresol novolac type epoxy resin (made by Nippon Kayaku Co., Ltd. molecular weight: 2500) (solid content: 80%) is mixed with 4 parts by weight of a photosensitive monomer (Aronix M315, trade name, made by Toa Gosei Co., Ltd.), 0.5 part by weight of an anti-foaming agent (S-65, trade name, made by Sannopuco Co., Ltd.) and 3.6 parts by weight of NMP under stirring.
   ②. 12 parts by weight of polyether sulphone (PES) is mixed with 14.49 parts by weight of epoxy resin particles (Polymerpol, trade name, made by Sanyo Kasei Co., Ltd.) having an average particle size of 0.5 µm and added with 20 parts by weight of NMP, which are mixed in a bead mill under stirring.
   ③. 2 parts by weight of an imidazole curing agent (2E4MZ-CN, trade name, made by Shikoku Kasei Co., Ltd.) is mixed with 2 parts by weight of a photoinitiator (Irgaquar I-907, trade name, made by Ciba Geigy), 0.2 part by weight of a photosensitizer (DETX-S, trade name, made by Nippon Kayaku Co., Ltd.) and 1.5 parts by weight of NMP under stirring.
   They are mixed to prepare the adhesive composition B for electroless plating.

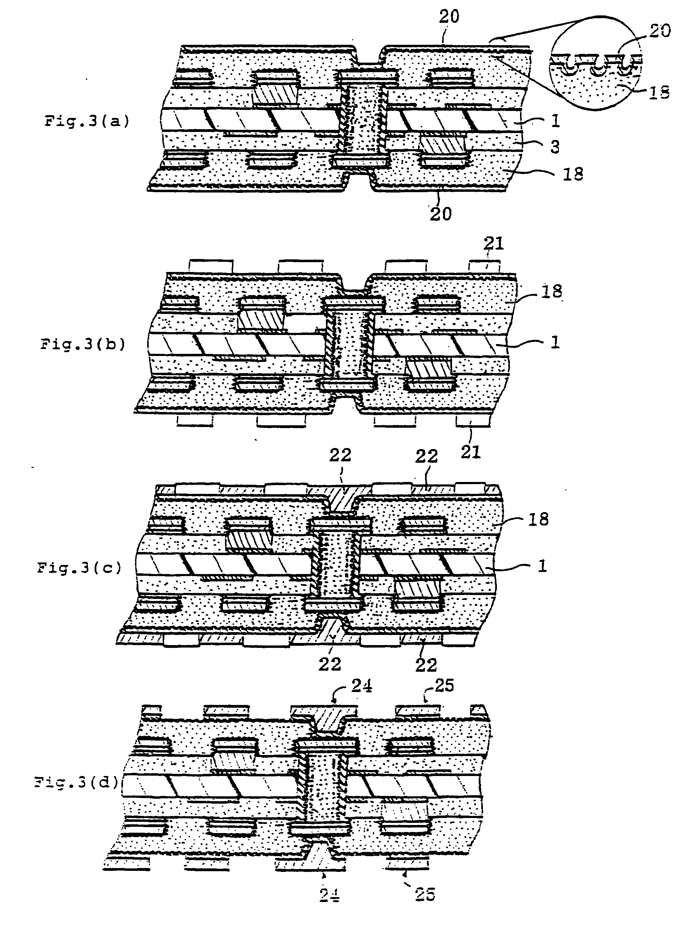

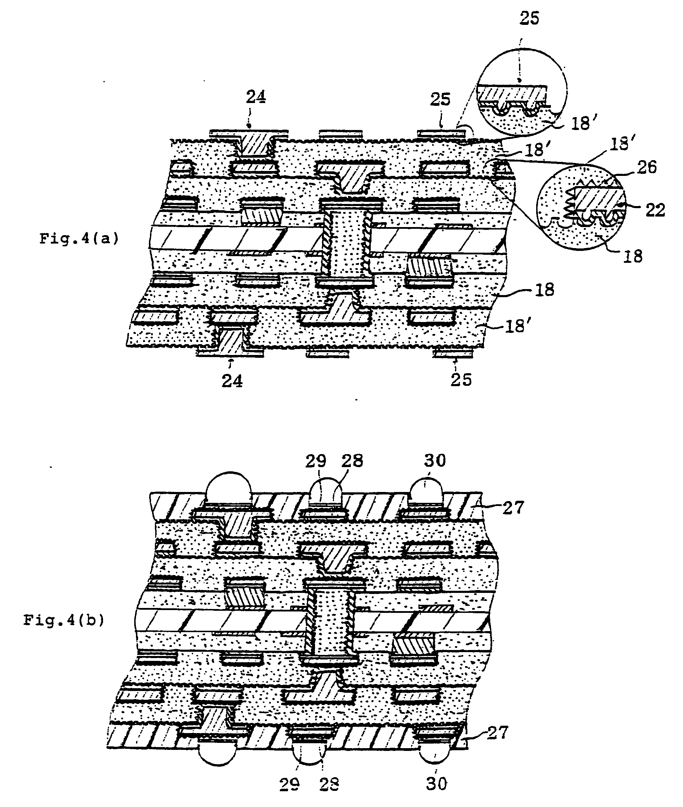

(11) The adhesive B for electroless plating prepared in the item (10) (viscosity: 1.5 Pa·s) is applied onto both surfaces of the board by means of a roll coater, left to stand at a horizontal state for 20 minutes and dried at 60°C for 30 minutes, and thereafter the adhesive A for electroless plating (viscosity: 1.0 Pa·s) is applied by means of a roll coater, left to stand at a horizontal state for 20 minutes and dried at 60°C for 30 minutes to form an adhesive layer 18 (two-layer structure) having a thickness of 40 µm (see Fig. 2(d), provided that the two-layer structure of the adhesive layer is not shown).
(12) To both surfaces of the board provided with the adhesive layer 18 are adhered photomask films depicted with black circles of 85 µmφ, which are exposed to a super-high pressure mercury lamp at 500 mJ/cm². It is developed by spraying a DMDG (diethylene glycol dimethyl ether) solution to form an opening for a via-hole of 85 µmφ in the adhesive layer. Further, the board is exposed to a super-high pressure mercury lamp at 3000 mJ/cm² and heated at 100°C for 1 hour and 150°C for 5 hours to form an interlaminar insulating layer (adhesive layer 18) of 35 µm in thickness having an opening (opening 13 for via-hole) with an excellent size accuracy corresponding to the photomask film (see Fig. 2(e)). Moreover, tin plated layer is locally exposed in the opening 19 for the via-hole.
(13) The board provided with the opening 19 for the formation of via-hole is immersed in chromic acid for 20 minutes to remove the epoxy resin particles existing on the surface of the adhesive layer, whereby the surface of the adhesive layer 18 is roughened into a roughness of Rmax = about 1-5 µm, which is immersed in a neutral solution (made by Shipley) and washed with water.
(15) The board is immersed in an electroless copper plating bath having the same composition as in the item (2) to form an electroless copper plated film 20 of 0.6 µm in thickness on the whole of the roughened surface (see Fig. 3(a)). In this case, the electroless copper plated film 20 is thin, so that the irregularities are observed on the surface of the electroless plated film 20 followed to the roughened surface of the adhesive layer 18.
(16) A commercially available photosensitive dry film is attached to the electroless copper plated film 20 and a mask is placed thereonto, which is exposed to a light at 100 mJ/cm² and developed with 0.8% sodium carbonate to form a plating resist 21 having a thickness of 15 µm (see Fig. 3(b)).
(17) Then, thickening of the conductor circuit and via-hole is carried out by subjecting to an electrolytic copper plating under the condition of the item (6) to form an electrolytic copper plated film 22 having a thickness of 15 µm (see Fig. 3(c)).
(18) After the plating resist is removed by dissolving with 5% KOH, the electroless plated film 20 beneath the plating resist 21 is removed by etching with a mixed solution of sulfuric acid and hydrogen peroxide to form conductor circuits 25 (including a via-hole 24) of 16 µm in thickness composed of the electroless plated film 20 and the electrolytic plated film 22 (see Fig. 3(d)).
Moreover, Pd retained on the roughened surface of the adhesive layer 18 is removed by immersing in chromic acid (800 g/l) for 1-10 minutes.
(19) The board provided with the conductor circuits 25 (inclusive of the via-hole 24) in the item (17) is immersed in an electroless plating solution of pH = 9 containing 8 g/l of copper sulfate, 0.6 g/l of nickel sulfate, 15 g/l of citric acid, 29 g/l of sodium hypophosphite, 31 g/l of boric acid and 0.1 g/l of a surfactant to form a roughened layer 26 of copper-nickel-phosphorus having a thickness of 3 µm on the surfaces of the conductor circuits. In this case, the roughened layer 26 indicates a composition ratio of copper: 98 mol%, nickel: 1.5 mol% and phosphorus: 0.5 mol% as analyzed by EPMA (fluorescent X-ray analysis).
Furthermore, the board is washed with water and immersed in an electroless tin substitution plating bath containing 0.1 mol/l of tin borofluoride and 1.0 mol/l of thiourea at 50°C for 1 hour to form tin substituted plated layer having a thickness of 0.05 µm on the surface of the roughened layer 26 (provided that tin substituted plated layer is not shown).
(20) By repeating the steps of the items (11)-(18) is further laminated an upperlayer interlaminar resin insulating layer 18' and conductor circuits 25 (inclusive of via-hole 24) to obtain a multilayer wiring board having three layers in its one surface (see Fig. 4(a)). In this case, the copper-nickel-phosphorus roughened layer 26 is formed on the surface of the conductor circuit, but the tin substituted plated layer is not formed on the surface of the roughened layer 26.
(21) On the other hand, a solder resist composition is obtained by mixing 46.67 parts by weight of a photosensitized oligomer (molecular weight: 4000) in which 50% of epoxy group in 60% by weight of cresol novolac type epoxy resin (made by Nippon Kayaku Co., Ltd.) dissolved in DMDG is acrylated, 14.121 parts by weight of 80% by weight of bisphenol A-type epoxy resin (Epikoye 1001, trade name, made by Yuka Shell Co., Ltd.) dissolved in methyl ethyl ketone, 1.6 parts by weight of an imidazole curing agent (2E4MZ-CN, trade name, made by Shikoku Kasei Co., Ltd.), 1.5 parts by weight of a polyvalent acryl monomer (R604, trade name, made by Nippon Kayaku Co., Ltd.) and 3.0 parts by weight of a polyvalent acryl monomer (DPE6A, trade name, made by Kyoeisha Kagaku Co., Ltd.) as a photosensitive monomer and 0.36 part by weight of a leveling agent made of a polymerized acrylic ester (Polyflow No.75, trade name, made by Kyoeisha Kagaku Co., Ltd.), adding 2.0 parts by weight of benzophenone (made by Kanto Kagaku Co., Ltd.) as a photoinitiator and 0.2 part by weight of EAB (made by Hodogaya Kagaku Co., Ltd.) as a photosensitizer and further adding 1.0 part by weight of DMDG (diethylene glycol dimethyl ether) to adjust a viscosity to 1.4 ± 0.3 Pa·s at 25°C.
Moreover, the measurement of the viscosity is carried out by means of B-type viscometer (DVL-B model, made by Tokyo Keiki Co., Ltd.) with a rotor No. 4 at 60 rpm or a rotor No. 3 at 6 rpm.
(22) The solder resist composition is applied onto both surfaces of the multilayer wiring board obtained in the item (19) at a thickness of 20 µm. After it is dried at 70°C for 20 minutes and 70°C for 30 minutes, it is adhered with a soda lime glass substrate of 5 mm in thickness depicted with circle pattern corresponding to an opening portion of the solder resist through a chromium layer so as to face the side of the chromium layer to the solder resist layer, which is exposed to a ultraviolet ray at 1000 mJ/cm² and developed with DMTG. Further, it is heated at 80°C for 1 hour, 100°C for 1 hour, 120°C for 1 hour and 150°C for 3 hours to form a solder resist layer 27 (thickness: 20 µm) opening a pad portion (opening size: 200 µm).
(23) Then, the board provided with the solder resist layer 27 is immersed in an electroless nickel plating solution of pH = 5 containing 30 g/l of nickel chloride, 10 g/l of sodium hypophosphite and 10 g/l of sodium citrate for 20 minutes to from a nickel plated layer 28 having a thickness of 5 µm in its opening portion. Further, the board is immersed in an electroless gold plating solution containing 2 g/l of gold potassium cyanide, 75 g/l of ammonium chloride, 50 g/l of sodium citrate and 10 g/l of sodium hypophosphite at 93°C for 23 seconds to form a gold plated layer 29 having a thickness of 0.03 µm on the nickel plated layer 28.
(24) Next, a solder is printed on the opening portion of the solder resist layer 27 and reflowed at 200°C to from a solder bump (solder body) 30, whereby a multilayer printed wiring board of four layers on its one surface having the solder bumps is produced (see Fig. 4(b)). Moreover, tin-silver, tin-indium, tin-zinc, tin-bismuth or the like can be used as the solder.

In the thus produced multilayer printed wiring board, a land shape of the through-hole in the multilayer core board can be true circle and a land pitch can be about 600 µm, so that the through-holes can be densely formed and the high densification of the through-holes can easily be attained. And also, the number of the through-holes can be increased in the board, so that the electrical connection to the innerlayer conductor circuits in the multilayer core board can sufficiently be ensured through the through-holes.

Accordingly, the invention is related to a multilayer printed wiring board comprising a multilayer core board having conductor layers in its innerlayer, and interlaminar resin insulating layers and conductor layers alternately laminated on a substrate to form buildup wiring layer connecting the conductor layers through via-hole, and wherein the multilayer core board has a resin insulating layer covering the innerlayer conductor circuits formed on the core material, a via-hole is formed in the resin insulating layer so as to arrive at the innerlayer conductor circuit through the layer, and a through-hole is formed in the resin insulating layer and the core material to pass therethrough and is filled with a filler, and a part of the via-holes in the buildup wiring layer is located just above the through-hole and directly connected to the through-hole.

Preferably, a conductor layer is formed so as to cover a surface of the filler exposed outward from an opening end of the through-hole, and a part of the via-hole in the buildup wiring layer is connected to the through-hole through the conductor layer.

Moreover, advantageously, the filler is made of metal particles and a thermosetting or thermoplastic resin.

### INDUSTRIAL APPLICABILITY

As mentioned above, in the printed wiring board according to the invention, the electrical connection to the innerlayer conductor circuits in the multilayer core board can sufficiently be ensured through the through-holes even if the core board is multilayered, so that there can be provided a high density wiring board suitable for the high densification of through-holes.

## Claims

1. A multilayer printed wiring board comprising;
a multilayer core board, and
a buildup wiring layer comprising interlaminar resin insulating layers (18, 18') and outer conductor circuit layers (9, 25) alternately laminated on the multilayer core board, and via-holes (24) formed in the interlaminar resin insulating layers (18, 18'), wherein
the multilayer core board comprises a core substrate (1) having inner conductor circuit layers (2) formed on the core substrate (1), a resin insulating layer (3) covering the inner conductor circuit layers (2), a via-hole (12) formed in the resin insulating layer (3) and a through-hole (10) formed in the resin insulating layer (3) and the core substrate (1) to pass therethrough,
said via-hole (12) formed in the resin insulating layer (3) connects the outer conductor circuit (9) of the buildup wiring layer and the inner conductor circuit (2) of the multilayer core board,
said through-hole (10) having a inner wall face roughened by a roughening treatment and being filled with a filler (8), and
a part of the via-holes (24) in the buildup wiring layer are connected to the through-hole (10).

2. A multilayer printed wiring board according to claim 1, **characterized in that** a conductor layer (13) is formed so as to cover a surface of the filler (8) exposing outward from an opening end of the through-hole (10), and a part of the via-holes (24) in the buildup wiring layer is connected to the through-hole (10) through the conductor layer (13).

3. A multilayer printed wiring board according to claim 1 or 2, **characterized in that** the filler (8) comprises metal particles and a thermosetting or thermoplastic resin.

4. A multilayer printed wiring board according to any one of the claims 1 to 3, **characterized in that** the via-hole (24) is filled with a plated film or a filler.

5. A multilayer printed wiring board according to any one of the claims 1 to 4, **characterized in that** the outer conductor circuit layer (9) or the conductor layer (13) comprises an electroless plated film and an electrolytic plated film formed on the electroless plated film.

6. A multilayer printed wiring board according to any one of the claims 1 to 5, **characterized in that** the interlaminar resin insulating layer (18, 18') comprises a composite of thermosetting and thermoplastic resins.

7. A multilayer printed wiring board according to any one of the claims 1 to 6, **characterized in that** a roughened layer is formed on a surface of the outer conductor circuit layer (9, 25) or the conductor layer (13).

8. A multilayer printed wiring board according to any one of the claims 1 to 7, **characterized in that** the core substrate (1) comprises resin substrate containing fibers.

9. A multilayer printed wiring board according to any one of the claims 1 to 8, **characterized in that** the formation of the opening (5) for the via-hole (12) is carried out by laser work.

10. A multilayer printed wiring board according to any one of the claims 1 to 9, **characterized in that** the inner wall face of the through-hole (10) is roughened by an oxidation-reduction treatment.

## Patentansprüche

1. Mehrschichtige, gedruckte Leiterplatte, die umfasst:
eine mehrschichtige Kernplatte, und
eine Aufbau-Verdrahtungsschicht, die interlaminare isolierende Harzschichten (18, 18') und äußere Leiterschaltkreisschichten (9, 25), die abwechselnd auf die mehrschichtige Kernplatte laminiert sind, sowie Kontaktlöcher (24) umfasst, die in den interlaminaren isolierenden Harzschichten (18, 18') ausgebildet sind, wobei
die mehrschichtige Kernplatte ein Kernsubstrat (1), das innere Leiterschaltkreisschichten (2) aufweist, die auf dem Kernsubstrat (1) ausgebildet sind, eine Harz-Isolierschicht (3), die die inneren Leiterschaltkreisschichten (2) abdeckt, ein Kontaktloch (12), das in der isolierenden Harzschicht (3) ausgebildet ist, und ein Durchgangsloch (10) umfasst, das in der isolierenden Harzschicht (3) und dem Kernsubstrat (1) so ausgebildet ist, dass es durch sie hindurch tritt,
wobei das in der isolierenden Harzschicht (3) ausgebildete Kontaktloch (12) den äußeren Leiterschaltkreis (9) der Aufbau-Verdrahtungsschicht und den inneren Leiterschaltkreis (2) der mehrschichtigen Kernplatte verbindet,
das Durchgangsloch (10) eine Innenwandfläche hat, die durch eine Aufrauungsbehandlung aufgeraut ist und mit einem Füller (8) gefüllt ist, und
ein Teil der Kontaktlöcher (24) in der Aufbau-Verdrahtungsschicht mit dem Durchgangsloch (10) verbunden sind.

2. Mehrschichtige, gedruckte Leiterplatte nach Anspruch 1, **dadurch gekennzeichnet, dass** eine Leiterschicht (13) so ausgebildet ist, dass sie eine Oberfläche des Füllers (8) abdeckt, die von einem Öffnungsende des Durchgangslochs (10) nach außen freilegt, und ein Teil der Kontaktlöcher (24) in der Aufbau-Verdrahtungsschicht über die Leiterschicht (13) mit dem Durchgangsloch (10) verbunden ist.

3. Mehrschichtige, gedruckte Leiterplatte nach Anspruch 1 oder 2, **dadurch gekennzeichnet, dass** der Füller (8) Metallteilchen und ein wärmehärtendes oder thermoplastisches Harz umfasst.

4. Mehrschichtige, gedruckte Leiterplatte nach einem der Ansprüche 1 bis 3, **dadurch gekennzeichnet, dass** das Durchgangsloch (24) mit einem plattierten Film oder einem Füller gefüllt ist.

5. Mehrschichtige, gedruckte Leiterplatte nach einem der Ansprüche 1 bis 4, **dadurch gekennzeichnet, dass** die äußere Leiterschaltkreisschicht (9) oder die Leiterschicht (13) einen stromlos abgeschiedenen Film und einen elektrolytisch abgeschiedenen Film umfasst, der auf dem stromlos abgeschiedenen Film ausgebildet ist.

6. Mehrschichtige, gedruckte Leiterplatte nach einem der Ansprüche 1 bis 5, **dadurch gekennzeichnet, dass** die interlaminare isolierende Harzschicht (18, 18') einen Verbundstoff aus wärmehärtendem und thermoplastischem Harz umfasst.

7. Mehrschichtige, gedruckte Leiterplatte nach einem der Ansprüche 1 bis 6, **dadurch gekennzeichnet, dass** eine aufgeraute Schicht auf einer Fläche der äußeren Leiterschaltkreisschicht (9, 25) oder der Leiterschicht (13) ausgebildet ist.

8. Mehrschichtige, gedruckte Leiterplatte nach einem der Ansprüche 1 bis 7, **dadurch gekennzeichnet, dass** das Kernsubstrat (1) Harzsubstrat umfasst, das Fasern enthält.

9. Mehrschichtige, gedruckte Leiterplatte nach einem der Ansprüche 1 bis 8, **dadurch gekennzeichnet, dass** die Ausbildung der Öffnung (5) für das Kontaktloch (12) durch Laserbearbeitung ausgeführt wird.

10. Mehrschichtige, gedruckte Leiterplatte nach einem der Ansprüche 1 bis 9, **dadurch gekennzeichnet, dass** die Innenwandfläche des Durchgangslochs (10) durch eine Oxidations-Reduktions-Behandlung aufgeraut wird.

## Revendications

1. Carte à circuit imprimé multicouche comprenant :
une carte centrale multicouche, et
une couche de connexion composite comprenant des couches isolantes en résine interlaminaires (18, 18') et des couches de circuit conducteur extérieur (9, 25) stratifiées de manière alternée sur la carte centrale multicouche, et des trous d'interconnexion (24) formés dans les couches isolantes en résine interlaminaires (18, 18'), dans laquelle
la carte centrale multicouche comprend un substrat central (1) ayant des couches de circuit conducteur intérieur (2) formées sur le substrat central (1), une couche isolante en résine (3) recouvrant les couches de circuit conducteur intérieur (2), un trou d'interconnexion (12) formé dans la couche isolante en résine (3), et un trou traversant (10) formé dans la couche isolante en résine (3) et le substrat central (1) pour passer à travers ceux-ci,
ledit trou d'interconnexion (12) formé dans la couche isolante en résine (3) connecte le circuit conducteur extérieur (9) de la couche de connexion composite et le circuit conducteur intérieur (2) de la carte centrale multicouche,
ledit trou traversant (10) ayant une face de paroi intérieure rendue rugueuse par un traitement de rugosité et étant rempli d'un élément de remplissage (8), et
une partie des trous d'interconnexion (24) dans la couche de connexion composite est connectée au trou traversant (10).

2. Carte à circuit imprimé multicouche selon la revendication 1, **caractérisée en ce qu'**une couche conductrice (13) est formée de manière à couvrir une surface de l'élément de remplissage (8) exposé vers l'extérieur à partir d'une extrémité ouverte du trou traversant (10), et qu'une partie des trous d'interconnexions (24) dans la couche de connexion composite est connectée au trou traversant (10) par le biais de la couche conductrice (13).

3. Carte à circuit imprimé multicouche selon la revendication 1 ou 2, **caractérisée en ce que** l'élément de remplissage (8) comprend des particules de métal et une résine thermodurcissable ou thermoplastique.

4. Carte à circuit imprimé multicouche selon l'une quelconque des revendications 1 à 3, **caractérisée en ce que** le trou d'interconnexion (24) est rempli d'une pellicule plaquée ou d'un élément de remplissage.

5. Carte à circuit imprimé multicouche selon l'une quelconque des revendications 1 à 4, **caractérisée en ce que** la couche de circuit conducteur extérieur (9) ou la couche conductrice (13) comprend une pellicule plaquée anélectrolytique et une pellicule plaquée électrolytique formée sur la pellicule plaquée anélectrolytique.

6. Carte à circuit imprimé multicouche selon l'une quelconque des revendications 1 à 5, **caractérisée en ce que** la couche isolante en résine interlaminaire (18, 18') comprend un composite de résines thermodurcissables et thermoplastiques.

7. Carte à circuit imprimé multicouche selon l'une quelconque des revendications 1 à 6, **caractérisée en ce qu'**une couche rendue rugueuse est formée sur une surface de la couche de circuit conducteur extérieur (9, 25) ou sur la couche conductrice (13).

8. Carte à circuit imprimé multicouche selon l'une quelconque des revendications 1 à 7, **caractérisée en ce que** le substrat central (1) comprend un substrat de résine contenant des fibres.

9. Carte à circuit imprimé multicouche selon l'une quelconque des revendications 1 à 8, **caractérisée en ce que** la formation de l'ouverture (5) pour le trou d'interconnexion (12) est exécutée par un travail au laser.

10. Carte à circuit imprimé multicouche selon l'une quelconque des revendications 1 à 9, **caractérisée en ce que** la face de la paroi intérieure du trou traversant (10) est rendue rugueuse par un traitement d'oxydoréduction.
